(19) Europäisches Patentamt / European Patent Office / Office européen des brevets

(11) **EP 4 696 890 A1**

(12) **EUROPEAN PATENT APPLICATION**

(43) Date of publication:
**18.02.2026 Bulletin 2026/08**

(21) Application number: **25195046.5**

(22) Date of filing: **11.08.2025**

(51) International Patent Classification (IPC):
**F04B 49/02** (2006.01)    **F04B 49/06** (2006.01)
**F04B 49/08** (2006.01)    **F04B 53/20** (2006.01)
**F24F 11/39** (2018.01)

(52) Cooperative Patent Classification (CPC):
**F04B 49/065; F04B 49/02; F04B 49/022;**
**F04B 49/08; F04B 53/20; F24F 11/39;**
F04B 2207/70; F04B 2207/703

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **12.08.2024 US 202463682066 P**

(71) Applicant: **Vertiv Corporation**
**Westerville, OH 43082 (US)**

(72) Inventors:
• **King, Jeremy Ryan**
  **Westerville, 43082 (US)**
• **Saleh, Adam Mustafa**
  **Westerville, 43082 (US)**
• **Garlock, Miles Lu**
  **Westerville, 43082 (US)**

(74) Representative: **Cousens, Nico et al**
**Kilburn & Strode LLP**
**Lacon London**
**84 Theobalds Road**
**London WC1X 8NL (GB)**

(54) **SYSTEM AND METHOD FOR COOLING SYSTEM PUMP CONTROL**

(57) A method of controlling a coolant distribution unit is disclosed. The method includes: starting, by a controller, a pump control mode; measuring, by a sensor, a differential pressure at a filter connected to a pump; determining, by the controller, whether the differential pressure is greater than a first predetermined value; upon determining that the differential pressure is greater than the first predetermined value, determining whether the differential pressure is greater than a second predetermined value, wherein the second predetermined value is greater than the first predetermined value; and upon determining that the differential pressure is less than or equal to the second predetermined value, generating a first output.

EP 4 696 890 A1

## Description

TECHNICAL FIELD

The present disclosure relates to a cooling system, and more specifically, to cooling systems and methods for use with data centers.

BACKGROUND

Buildings or facilities with large numbers of electronic devices consume a large amount of electric power. Electronic devices generate undesirably high heat when in use, which must be removed to prevent a failure of the devices. Among various buildings or facilities, data centers have ever-rising heat density, requiring thermal systems to provide increased cooling density as demands for computing power continue to grow. One common electronic device or server cooling method includes an air-cooling method. Electronic devices or computing systems' power requirements remained below a certain level, e.g., 20 kW, data centers could rely on air cooling to maintain safe operating temperatures by circulating cold air around hardware devices. But today's high-performing computing systems can easily exceed 20 kW or more. This is, in large part, because the computing systems within racks are configured with central processing units (CPUs) and graphics processing units (GPUs), that have much higher thermal power densities than previous generations. Although some air-cooling systems can support racks that require more than 20 kW of power, they tend to be inefficient and complicated to maintain, causing more attention to other solutions using fluid.

Such server cooling in data centers is thus transitioning from air cooling to more efficient fluid cooling solutions. Fluid cooling also known as liquid cooling can bring several benefits including reducing energy costs, reducing the carbon footprint, increasing power density, higher cooling requirements, targeted cooling options, and significantly improved heat transfer (e.g., water has 4,000 times the heat capacity compared to the same volume of air), thus greatly enhancing energy efficiency, and improved possibilities for utilizing waste heat, thereby significantly reducing the power usage effectiveness (PUE) of a data center. Moreover, more efficient cooling allows for more powerful server components, including higher processor clock speeds, substantially increasing power density within servers and entire data centers.

Liquid cooling systems include chip-scale cold plate liquid cooling systems and immersion liquid cooling systems. The cold plate-type liquid cooling system is directly provided with a metal cavity on the server chip, and the direct cooling of the chip is realized through the circulating flow of cooling liquid. Direct-to-chip cooling - sometimes referred to as direct-to-plate cooling - integrates the cooling system directly into the computer's chassis. Cool liquid is piped to cold plates that sit directly next to components such as CPUs, GPUs, memory cards, etc. Small fluid channels can carry the cool liquid to each plate, where the liquid draws off the heat from the underlying components. The warm liquid is then circulated to a cooling device or heat exchange. After it's been cooled, the liquid is then circulated back to the cold plates.

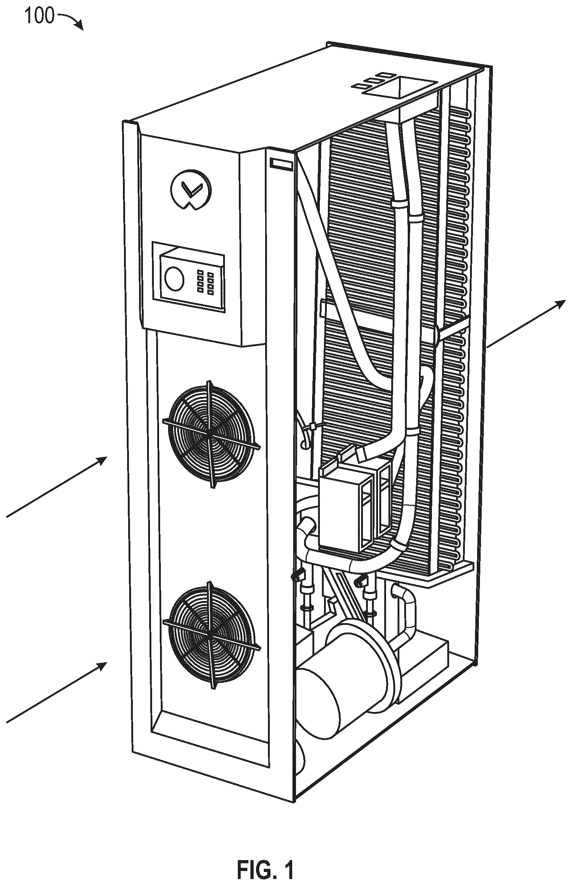

For instance, cold plate-type liquid cooling servers are vertically installed on a cooling rack, a main pipeline for centralized liquid supply and return is arranged on the cooling rack, and the main pipeline is connected with a liquid cooling secondary side main pipeline of a coolant distribution device (CDU) below or above the cooling rack to form a cooling loop. Because liquid is more efficient than air at transferring heat, CDUs can be introduced where higher rack densities have increased the heat being produced beyond the capability of air-cooled systems. The CDU network exchanges heat between the building's existing facility cooling systems or liquid loop (FWS) and the CDU loop (TCS), which runs closer to the IT equipment. Referring to FIG. 1, which shows a CDU functioning as a liquid-to-air heat exchanger for cooling chips according to a related art, server fans blow warm air through the exchanger, which dissipates the heat. The liquid is circulated through a closed-loop system that carries out the heat exchange. The liquid cooling plate servers are simultaneously connected with the main pipeline of the cooling rack so as to be connected with the cooling liquid. Coolant distribution units create an isolated secondary loop separate from the chilled water supply, enabling strict containment management and precise control of the liquid cooling system's temperature, pressure, and flow rate.

One drawback of such a liquid-cooled direct-to-chip application includes making sure the liquid flowing to cool servers is clean. The cleanliness of the fluid in a liquid-cooled direct-to-chip application is critical for targeted cooling operation. For this reason, CDUs are typically installed with filter(s) to capture a diameter of about $25\mu$ (e.g., a white blood cell is $25\mu$) to $50\mu$ (e.g., human hair ranges from 50 to $100\mu$) to protect cold plates. Because the filter(s) can capture small contaminates the filter(s) is prone to rupturing due to clogging. However, current control efforts have exaggerated the problem of filter clogging. As the filter(s) clogs a pump speed(s) will increase to meet the IT load flow requirement further raising a differential pressure across the filter(s). A failed filter can be catastrophic to the entire data center system and lead to damaged cold plates let alone CPUs, GPUs, and any other electronic components in a server racker.

Therefore, there exists a need to ensure the cleanness of the filters and prevent a failure of the data center cooling system and servers occurred due to filter failure and/or contamination. Further, a need to efficiently control the cooling unit even when filter contamination is predicted to effectively discreetly control cooling across the data center servers.

SUMMARY

This section provides a general summary of the disclosure and is not a comprehensive disclosure of its full scope or all of its features. Embodiments described herein relate to techniques for cooling data centers. In particular, systems and methods of the present disclosure provide new and novel techniques for detecting an error in advance to prevent a failure of a coolant distribution device (CDU) for data centers let alone data center servers. For example, CDUs having one or more pumps and respective one or more filters may malfunction due to contamination in the CDUs. When contaminated fluid passes through the CDUs, the filters thereof can be clogged and damaged. Currently, a dirty filter or filters can be noticed by an alarm (e.g., non-critical alarm) with a user setpoint based on operating conditions. By adding an additional alarm (e.g., critical alarm) to selectively shut down CDU components (e.g., filter) when a differential pressure across the filter(s) is outside a threshold, it is possible to prevent a catastrophic failure and reduce liability. Further, this additional alarm can help set the product line apart and secure more sales.

The systems and methods according to the present disclosure can be implemented into existing a liquid cooling management system or coolant distribution unit. The present disclosure encompasses methods for providing additional steps to control pump units when a malfunction is detected. While the methods described herein can be applied to a coolant distribution unit providing liquid coolant to a server rack, the present disclosure can be applied to any system comprising a pump and a filter communicating with the filter, and a coolant flowing therethrough.

In accordance with an embodiment of the present disclosure, a method of controlling a coolant distribution unit includes: starting, by a controller, a pump control mode; measuring, by a sensor, a differential pressure at a filter connected to a pump; determining, by the controller, whether the differential pressure is greater than a first predetermined value; upon determining that the differential pressure is greater than the first predetermined value, determining whether the differential pressure is greater than a second predetermined value, wherein the second predetermined value is greater than the first predetermined value; and upon determining that the differential pressure is less than or equal to the second predetermined value, generating a first output. In some embodiments, the step of generating the first output includes determining that the filter is dirty.

In some embodiments, the method further includes: returning to the step of starting the pump control mode upon determining that the differential pressure is smaller than or equal to the first predetermined value; and generating a second output upon determining that the differential pressure is greater than the second predetermined value. The method further includes a step of turning off the pump.

In some embodiments, when there are a plurality of pumps, the step of turning off the pump includes turning off all of the plurality of pumps. The method further includes: receiving a user input whether the filter is cleaned or not; generating a third output upon determining that the filter is cleaned; and turning on the pump. The first, second, and third outputs are different from each other. In some embodiments, the method further includes determining a specific filter having the differential pressure greater than the first predetermined value among the plurality of filters when the pump and the filter are provided in plural.

In some embodiments, the method further includes: determining whether the differential pressure of the specific filter is greater than the second predetermined value; generating a second output and turning off the specific pump in fluid communication with the specific filter upon determining that the differential pressure of the specific filter is greater than the second predetermined value; decreasing a temperature setpoint based on a pump speed decrease; and turning on the specific pump when it is determined that the specific filter in fluid communication with the specific pump is cleaned.

In some embodiments, the method further includes: generating a second output upon determining that the differential pressure is greater than the second predetermined value; determining again whether the differential pressure is greater than the second predetermined value; setting a filter setpoint upon determining that the differential pressure is greater than the second predetermined value; decreasing a temperature setpoint based on a pump speed decrease; receiving a user input whether the filter has been cleaned or not upon determining that the differential pressure is smaller than or equal to the second predetermined value; and generating a third output upon determining that the filter is cleaned. The first, second, and third outputs are different from each other.

In accordance with another embodiment of the present disclosure, a coolant distribution unit includes: a heat exchanger; a pump selectively communicating with the heat exchanger by a valve; a filter communicating with the pump; a sensor configured to measure a differential pressure at the filter connected to the pump; and a controller configured to a pump control mode and determine whether the differential pressure is greater than a first predetermined value. In some embodiments, the pump and the filter are provided in plural.

Other aspects and advantages of the invention will become apparent from the following detailed description, taken in conjunction with the accompanying drawings, illustrating by way of example the principles of the invention.

BRIEF DESCRIPTION OF THE DRAWINGS

The disclosure will be readily understood by the following detailed description in conjunction with the accompanying drawings, wherein like reference numerals designate like elements:

FIG. 1 illustrates a front perspective view of a coolant distribution device (CDU), partially covered, of a related art;
FIG. 2A illustrates a front perspective view of the CDU, without a cover, according to the related art;
FIG. 2B illustrates a rear perspective view of the CDU, without a cover, according to the related art;
FIG. 3 illustrates a rear perspective view of a CDU, without a cover, according to another related art;
FIG. 4 illustrates a schematic of the CDU of FIG. 1;
FIG. 5 illustrates a schematic of the CDU of FIG. 3;
FIG. 6 illustrates a flowchart of a control method according to a first exemplary embodiment of the present disclosure;
FIG. 7 illustrates a flowchart of a control method according to a second exemplary embodiment of the present disclosure; and
FIG. 8 illustrates a flowchart of a control method according to a third exemplary embodiment of the present disclosure.

DETAILED DESCRIPTION

Aspects of the disclosure are described more fully hereinafter with reference to the accompanying drawings, which form a part hereof, and which show, by way of illustration, example features. The features can, however, be embodied in many different forms and should not be construed as limited to the combinations set forth herein; rather, these combinations are provided so that this disclosure will be thorough and complete and will fully convey the scope. The following detailed description is, therefore, not to be taken in a limiting sense.

The use of a singular term, such as, but not limited to, "a," is not intended as limiting of the number of items. The use of relational terms, such as, but not limited to, "top," "bottom," "left," "right," "upper," "lower," "down," "up," "side," and the like are used in the written description for clarity in specific reference to the Figures and are not intended to limit the scope of the inventions or the appended claims. The terms "including" and "such as" are for illustrative purposes but not limited thereto. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume, and density, among others.

Servers have become very important, particularly since institutions, companies, and consumers use the Cloud daily. The number of data centers keeps increasing. Servers also become more and more powerful and therefore, generate more and more heat. While still widely used in data centers, the potential of traditional air-cooling systems is limited, more so when taking the impact on the environment into account. A few technologies based on liquid emerged, among them is direct liquid cooling (DLC), also called direct-to-chip liquid cooling. With this technique, only high power-consuming components are cooled: processors, graphics cards, etc. The principle of the DLC is to establish a cooling loop. Cold liquid is sent to cold plates, mounted directly on the hot electronic components, and absorbs the heat which is sent to a coolant distribution unit (CDU) to a heat exchanger whose function is to dissipate the heat. They are usually located in the rack or shared by rows. When the liquid has been cooled, it is returned to the cold plates, thus closing the cooling loop. Practically, not all the heat generated by the processors is removed through liquid cooling, and there is still some percentage of heat removed by air cooling. Thus, the entire environment is a hybrid liquid-air cooling system.

CDUs are essential components that ensure liquid-cooled systems meet expectations. Operation logic integrated into intelligent controllers combined with smart control manages server and data center cooling system performance. CDUs contain a pump that circulates coolant through a network of pipes or channels, distributing it to various components like servers, processors, or other high-heat components in large, high-power devices that need cooling. CDUs may also contain valves, filters, and other components to control and monitor coolant flow.

The present disclosure offers a solution for predicting a failure of CDUs caused due to filter rupture before the failure occurs. Further, the present disclosure can reduce the blast radius of pump failure to single cold plates within individual servers with a simpler, higher-resilient product.

It is understood that the use of specific component, device and/or parameter names and/or corresponding acronyms thereof, such as those of the executing utility, logic, and/or firmware described herein, are for example only and not meant to imply any limitations on the described embodiments. The embodiments may thus be described with different nomenclature and/or terminology utilized to describe the components, devices, parameters, methods and/or functions herein, without limitation. References to any specific protocol or proprietary name in describing one or more elements, features or concepts of the embodiments are provided solely as examples of one implementation, and such references do not limit the extension of the claimed embodiments to embodiments in which different element, feature, protocol, or concept names are utilized. Thus, each term utilized herein is to be given its broadest interpretation given the context in which that term is utilized.

As utilized herein, the term "coolant distribution unit" (as in CDU) generally refers to the configuration of an integral part of liquid cooling systems designed to increase overall system. The CDU circulates and pumps coolant in a closed-loop system within the rack and server chassis and utilizes facility water (in full liquid cooling systems) and the air outside the rack to cool the servers. The CDU is designed to manage high heat loads for accelerated compute and high-density data center environments, providing critical cooling capacity and heat removal functions. The CDU provides controlled, contaminant-free coolant for heat exchangers, direct-to-chip, and immersion cooling devices.

The term "rack," also known as a server cabinet generally refers to a type of framework that is usually made from steel and houses servers, cables, and other equipment. A CDU communicates with a rack to provide cold liquid fluid (or coolant) to servers inside the rack, which is then returns back to the CDU as heated. Details of CDU are described hereinbelow.

Coolant Distribution Device (CDU)

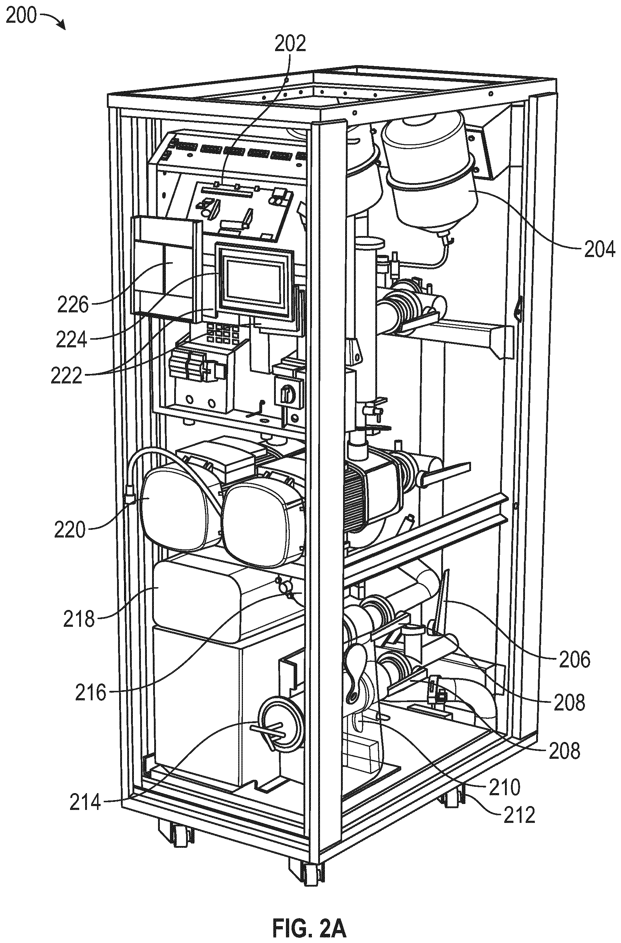

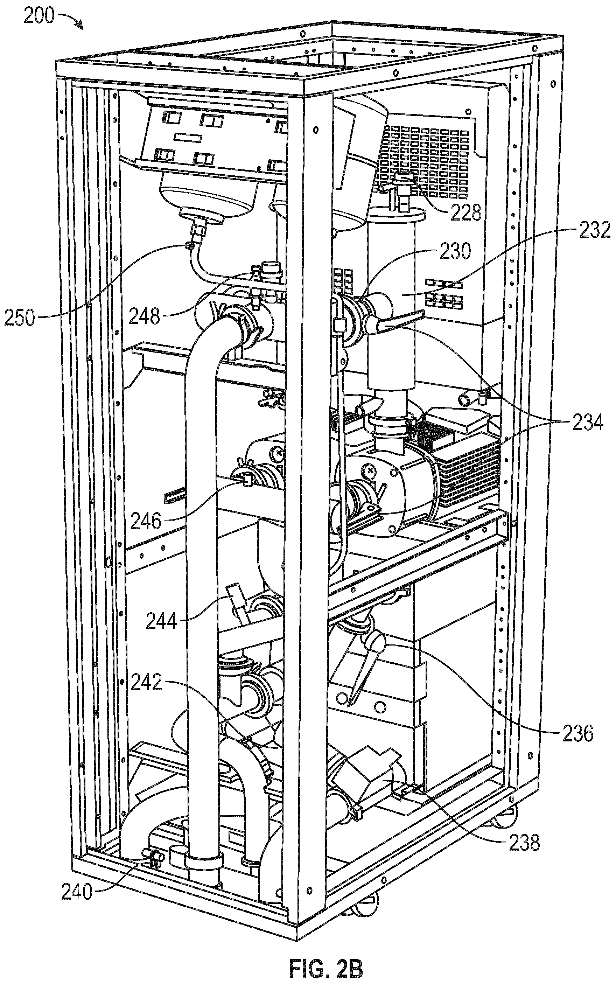

FIG. 2A illustrates a front perspective view of a CDU 200 according to a related art, without a cover. FIG. 2B illustrates a rear perspective view of the CDU 200 according to the related art, without a cover.

Referring to FIGS. 2A and 2B, the CDU 200 includes a controller or processor 202, one or more expansion vessels 204, a primary filter by-pass valve 206 (if fitted), one or more primary filter isolation valves 208 (if fitted), a water make-up container 210, wheels and adjustable feet 212, an optional primary filter 214, a filling pump 216, a plate heat exchanger 218, one or more secondary pumps 220, one or more pump inverter drives 222, a controller touch screen 224, and various sensors 226 including room temperatures and RH sensors. The CDU 200 further includes an auto air vent 228, a pressure relief valve 230, one or more optional secondary filters 232 respectively communicating with the one or more secondary pumps 220, one or more filter/pump isolation valves 234, a by-pass shut-off valve 236, a primary cooling valve 238, one or more drain valves 240, a secondary flow meter 242, a primary flow meter 244, one or more level sensors 246, one or more pressure sensors 248, and one or more manual air vents 250.

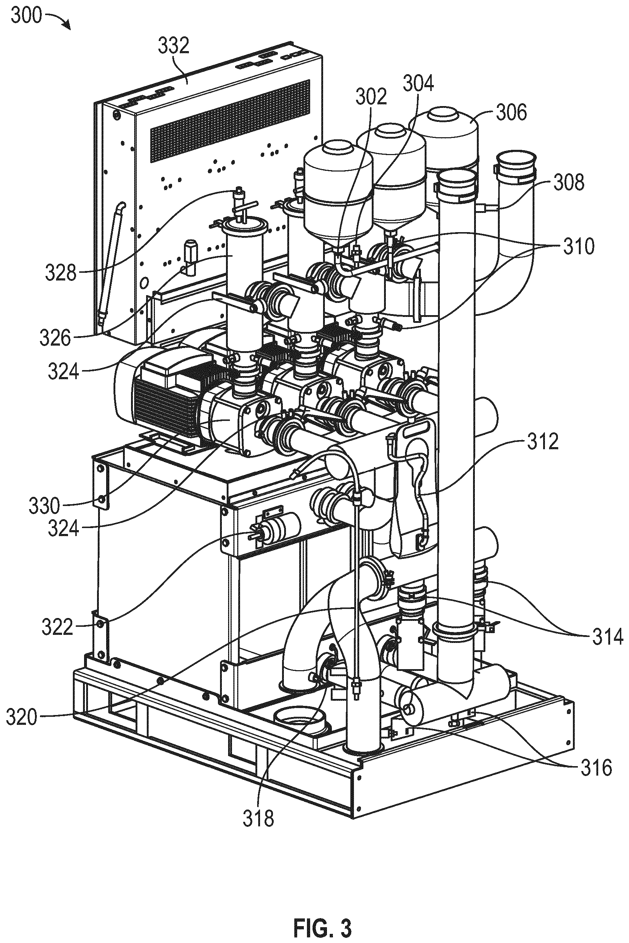

FIG. 3 illustrates a rear perspective view of a CDU 300, without a cover, according to another related art. The CDU 300 includes similar components to the CDU 200, for example, one or more manual vents 302, a pressure relief valve 304, one or more expansion vessels 306, a secondary flow meter 308, one or more pressure sensors 310, a flexible make-up container 312, one or more primary cooling valves 314, one or more drain valves 316, a primary flow meter 318, a filling wand 320, a fill pump 322, one or more filter/pump isolation valves 324, one or more secondary filters 326, an auto air vent 328, one or more secondary pumps 330 respectively communicating with the one or more secondary filters 326, and a controller 332 having a power supply, pump inverter drivers, a touch screen, and one or more sensors.

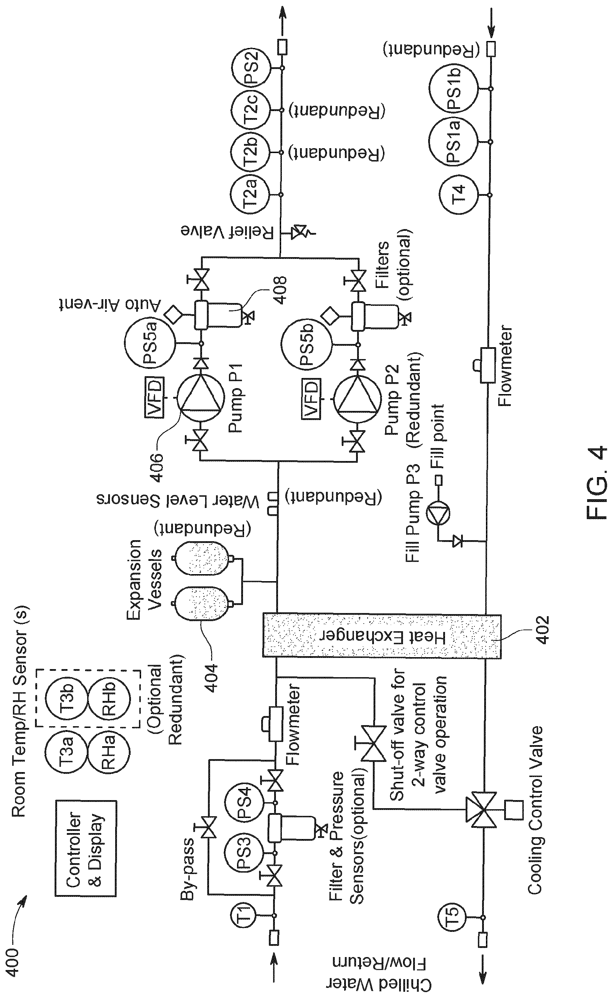

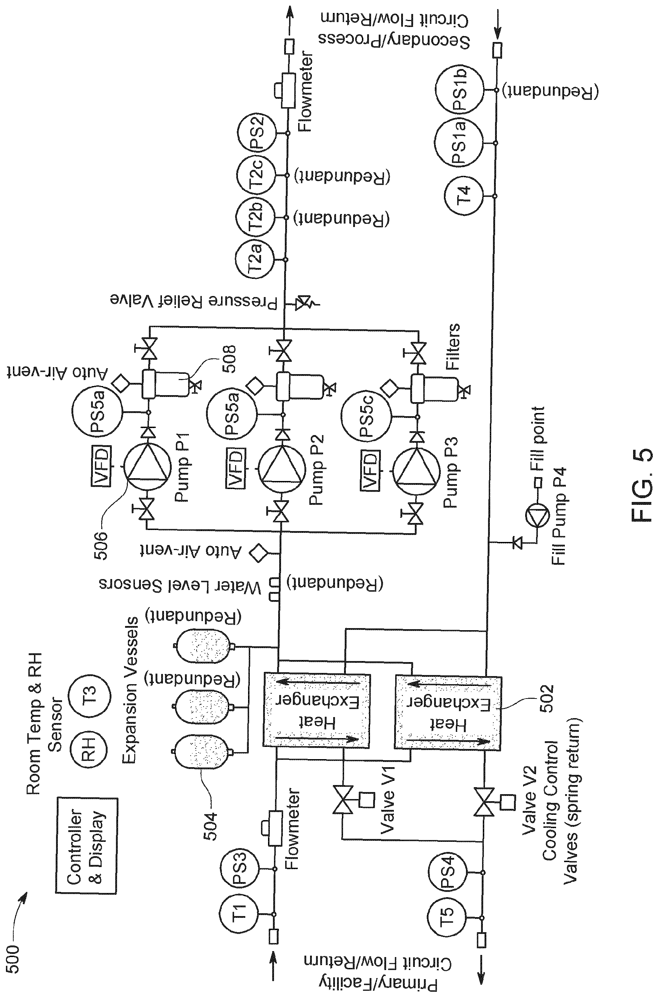

FIG. 4 illustrates a schematic 400 of the CDU of FIGS. 2A and 2B, and FIG. 5 illustrates a schematic 500 of the CDU of FIG. 3.

The schematic 400 shows a heat exchanger 402, which corresponds to the plate heat exchanger 218 in FIG. 2A; one or more expansion vessels 404, which correspond to the one or more expansion vessels 204 in FIG. 2A; one or more pumps 406, which correspond to the one or more pumps 220 in FIG. 2A; and one or more filters 408, which correspond to one or more optional secondary filters 232 in FIG. 2A. In addition, a separate fluid circuit with hot and cold flow lines extends from the CDU 200 for directing fluid, for example water, from a separate heat exchange circuit for exchanging heat with the cooling fluid that flows through the heat exchanger 402. In use, returning heated coolant flows into inlets of the one or more pumps 406. Outlets of the one or more pumps 406 are connected to the one or more filters 408, respectively, for filtering the coolant and then into the heat exchanger 402. Flow through the one or more filters 408 can be selectively shut-off using suitable valves, for example when changing thereof, with the flow then being directed through the fluid line to the filter that is being used. The components of the CDU 200 are arranged in the flow path in a manner to regulate the pressure provided to a server rack. The CDU 200 can also allow change out of one of the pumps while coolant is still delivered using the remaining pump.

The schematic 500 shows similar components to those above. The main differences between the schematic 400 or CDU 200 and the schematic 500 or CDU 300 are the number of components, the size of the unit, etc., for different applications. For instance, the CDU 200 may be used in a smaller space where less heat and power are necessary compared to the CDU 300. Thus, the details of the CDU 300 components are omitted herein.

Each CDU includes one or more pumps such that, based on the need, one or more pumps may be selectively controlled. The CDUs 200, 300 have configurations suitable for achieving uniform pressure delivery, by operating a pump(s), filter(s), heat exchanger(s), fluid passageways, and the like. The elements of the CDUs 200, 300 can collectively create a flow restriction impacting delivery pressure to a server rack(s). The CDUs 200, 300 described herein may be designed so that the various flow restrictions provided by the various elements thereof result in the internal gauge pressure of the electronic devices being regulated, reducing the range in pressure change with respect to changes in pump speed or the like.

The CDUs as described above can distribute liquid evenly throughout the system. The CDUs can pump cooled fluid to server racks (or cold plates) in a closed loop, with precision control adjusting fluid temperature and flow rates to maximize efficiency, thus supplying coolant in stable conditions, while the heated coolant due to heated devices in the server racks can be cooled by a separate coolant passing through a heat exchanger.

The server racks securely hold rack-mountable systems. The rack-mountable systems may be, e.g., high-power central processing units (CPUs), graphical processing units (GPUs), a server blade, a power supply unit, a keyboard, video, and mouse (KVM) switch, a network patch panel, or the like. One or more cold plates may be arranged, directly or indirectly, on the corresponding rack-mountable systems. The cold plates can be any suitable type of cold plate, such as a tubed cold plate or a cold plate comprising internal fins or channels (e.g., microchannels), and may be made of any suitable material, such as copper, aluminum, or stainless steel, that is chemically compatible with immersion and working fluids.

In addition, the rack-mountable systems may be heat-generating electronic devices including one or more IT components (e.g., central processing units or CPUs, graphical processing units (GPUs), memory, and/or storage devices). Each IT component may perform data processing tasks, where the IT component may include software installed in a storage device, loaded into the memory, and executed by one or more processors to perform the data processing tasks. Further, the server blade may include a host server (referred to as a host node) coupled to one or more compute servers (also referred to as computing nodes, such as CPU server and GPU server). The host server (having one or more CPUs) typically interfaces with clients over a network (e.g., Internet) to receive a request for a particular service such as storage services (e.g., cloud-based storage services such as backup and/or restoration), executing an application to perform certain operations (e.g., image processing, deep data learning algorithms or modeling, etc., as a part of a software-as-a-service or SaaS platform). In response to the request, the host server distributes the tasks to one or more of the performance computing nodes or compute servers (having one or more GPUs) managed by the host server. The performance compute servers perform the actual tasks, which may generate heat during the operations.

As described above, CDUs each includes a computing system or controller ("202" in FIG. 2A or "332" FIG. 3). The controller may periodically or constantly monitor the operating status of the respective CDU. The operating data of the operating status may include the operating temperatures of each processor, cooling liquid, an airflow, differential pressure, flow speed, etc., measured in real-time. The computing system or controller may be a multiprocessor system comprising processor units. The processor units comprise multiple processor cores. The processor units can execute computer-executable programs. The computing system can comprise any number of processor units. Further, a processor unit can comprise any number of processor cores. A processor unit can take various forms such as a central processing unit (CPU), a graphics processing unit (GPU), general-purpose GPU (GPGPU), accelerated processing unit (APU), field-programmable gate array (FPGA), neural network processing unit (NPU), data processor unit (DPU), accelerator (e.g., graphics accelerator, digital signal processor (DSP), compression accelerator, artificial intelligence (AI) accelerator), controller, or other types of processing units. As such, the processor unit can be referred to as an XPU (or xPU). Further, a processor unit can comprise one or more of these various types of processing units. In some embodiments, the computing system comprises one processor unit with multiple cores, and in other embodiments, the computing system comprises a single processor unit with a single core. As used herein, the terms "processor unit" and "processing unit" can refer to any processor, processor core, component, module, engine, circuitry, or any other processing element described or referenced herein. Further, in some embodiments, the computing system can comprise one or more processor units that are heterogeneous or asymmetric to another processor unit in the computing system. There can be a variety of differences between the processing units in a system in terms of a spectrum of metrics of merit including architectural, microarchitectural, thermal, power consumption characteristics, and the like. These differences can effectively manifest themselves as asymmetry and heterogeneity among the processor units in a system.

Coolant Distribution Unit (CDU) Shutdown Filter Protection

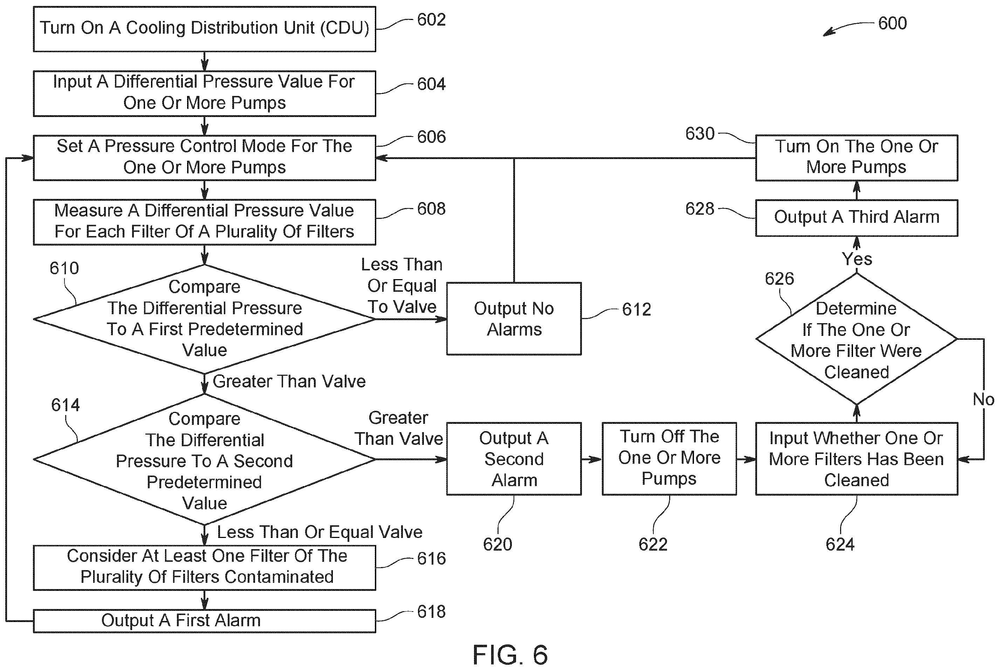

Hereinafter, a method 600 of controlling a CDU according to a first embodiment is described with reference to FIG. 6. In step 602, the method 600 begins the operation by turning on the CDU (e.g., CDU 200 or 300). In steps 604 and 606, a user may enter various settings, e.g., an input differential pressure value, and start a pressure control for one or more pumps (e.g., one or more pumps 406 or 506) to be in a pump control mode. In step 608, a differential pressure for each filter, e.g., an inlet pressure before entering the filter and an outlet pressure existing the filter, is measured. Then, step 610 checks whether the measure differential pressure in step 608 is greater than a first predetermined value, e.g., 6 psi. The first predetermined value may be determined based on the types of CDU or cooling/power required for the data center servers and can be set by a user. If it is determined that the differential pressure is less than or equal to the first predetermined value, the method determines that no alarm is necessary in step 612 and repeats the process from step 606.

In some embodiments, if it is determined that the measured differential pressure is greater than the predetermined value, the method continues to step 614 and checks whether the measured differential pressure is greater than a second predetermined value. The second predetermined value is greater than the first predetermined value, e.g., 10 psi which can be also determined and set by a user. In step 616, if it is determined that the second predetermined value is less than or equal to the second predetermined value (e.g., the measured differential pressure may be 8 psi), it is considered that at least one of the one or more filters for the corresponding differential pressures are contaminated in step 616. In step 618, the CDU outputs a first alarm to notify a user that at least one of the one or more filters is dirty. The first alarm may be in the form of visual by colors, sound, vibration, etc. Herein, the term "alarm" or "output" can be interchangeable used and understood as a notification configuration for a user.

In some embodiments, if the measured differential pressure is greater than the second predetermined value (e.g., 11 psi or more) in step 614, the method continues to step 620 to output a second alarm. The second alarm may be in the form of visual by colors, sound, vibration, etc. In addition, while the first alarm may be outputted in yellow light, the second alarm may be outputted in red light to inform the severity of one or more filters' status. Alternatively, when the first and second alarm include a sound alarm, the second alarm may be louder than (e.g., higher volume) the first alarm. In addition, after the second alarm is outputted, the method 600 may turn off, in step 622, all the one or more pumps to securely prevent a failure of the CDU.

In some embodiments, once the CDU stops operating, a user may replace or clean one or more filters in step 624. In step 626, the CDU determines whether the filter is cleaned, by manually entering/resetting or determined by a sensor of the CDU. If "yes," the CDU can output a third alarm (e.g., green light, sound, or haptic) in step 628 to inform a user that the one or more filters are clean. In step 630, once it is confirmed that all the filters are cleaned/replaced, the CDU then turn on all of the one or more pumps, by the controller. The method then repeats the process from step 606. However, if it is determined that the cleaned is not cleaned in step 626, the method 600 goes back to step 624 to confirm that the user changes or cleans the filters.

The method 600 promotes, while the CDU may be in normal operation if the differential pressure at one or more filters is higher than a predetermined setting value, an alarm to be outputted. Then, the method 600 can perform an additional check by setting a secondary predetermined value, e.g., a factory preset differential pressure that is higher than the initial predetermined value, the CDU is entirely turned off. A user can re-start the operation of the CDU after all the filters are cleaned or replaced and a green light alarm is outputted. Thus, method 600 can ensure prevention of a failure of cooling systems let alone data center servers.

CDU Pump Shutdown Filter Protection

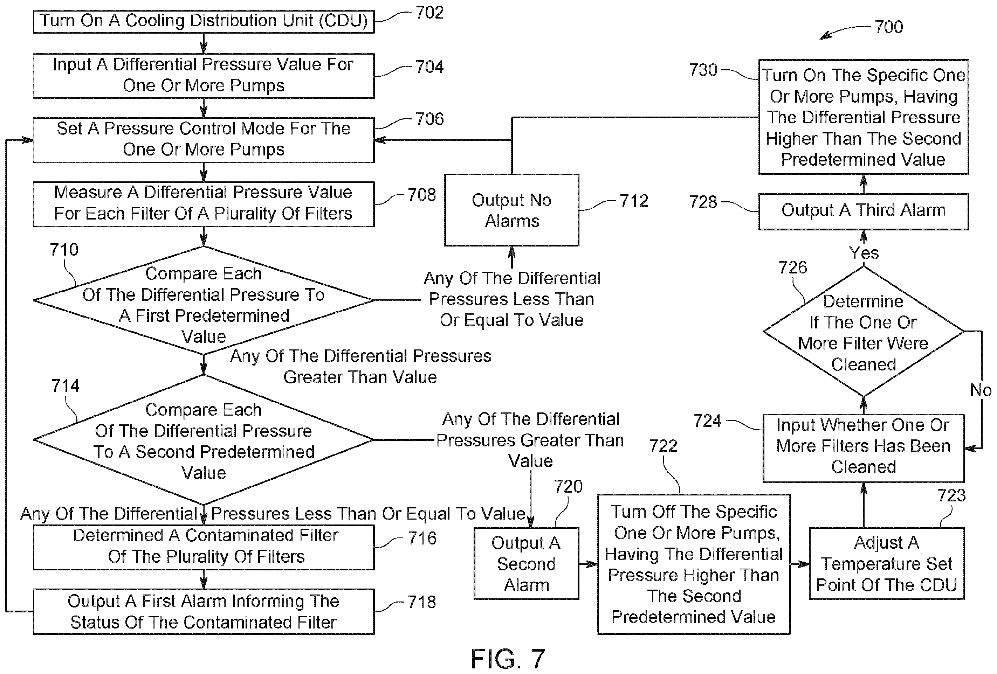

FIG. 7 illustrates a flowchart of a control method 700 according to a second exemplary embodiment of the present disclosure. In some embodiments, the method 700 includes similar steps to the method 600, e.g., steps 702-712 are similar to the above-described steps 602-612, respectively, of the method 600. However, while the method 700 includes step 714 in which a particular filter of the one or more filters is determined and analyzed, the method 600 does not determine a particular filter but merely considers a failure of any one among the one or more filters. For instance, if the method 700 determines that a measure differential pressure for a specific filter (e.g., a difference between a pressure before entering a filter(s) and after exiting the filter(s)) is greater than a first predetermined value in step 710, by checking each differential pressure at the filters when there is more than one filter, the corresponding filter is checked whether the measure differential pressure is greater than a second predetermined value. The second predetermined value may be greater than the first predetermined value, e.g., the first predetermined value may be 6 psi while the second predetermined value may be 10 psi. In step 716, when the method determines the contaminated filter, the method proceeds to step 718 to output a first alarm informing the specific filter's status in the form of visual, sound, or haptic. In some embodiments, when more than one filter may be determined to be dirty, the first alarm may inform that more than one filters are contaminated with indication of which filters.

In some embodiments, in step 720, a second alarm may be output to inform that the determined dirty filter needs to be cleaned when it is determined that the differential pressure is greater than the second predetermined value in step 714. Similar to the method 600, the second alarm may be in the form of visuals by colors, sound, vibration, etc. In addition, while the first alarm may be outputted in yellow light, the second alarm may be outputted in red light to inform the severity of one or more filters' status. Alternatively, when the first and second alarms include sound, the second alarm may be louder than (e.g., higher volume) the first alarm.

After the second alarm is output in step 720, the specific one or more pumps, having the differential pressure higher than the second predetermined value, are turned off, without turning off all the pumps or the CDU in step 722. In certain cases, all of the filters may need to be cleaned. When the specific one or more pumps are turned off, one or more check valves respectively connected to the one or more pumps or filters are also turned off to present fluid flowing through the dirty filter or filters. After step 722, a temperature setpoint may be lowered by 5°R for every pump speed reduced by a percentage in step 723 to compensate for the temperature increase caused by turning off one or more pumps. In detail, in step 723, when a pump is turned off due to the corresponding dirty filter, the rest of the pumps ramp up to meet the duty point. If the duty point is not met, the flow rate is lower than before and the temperature on the secondary circuit will start to increase due to insufficient heat rejection. For example, if the cooling unit is running at 3 pumps 80%. When one pump shuts down, the other two pumps will ramp up to 100%. The original speed is at $3 \times 80\% =$ 240%, but now it is $2 \times 100\% = 200\%$. It is about 40% reduction and the secondary temperature set point can now be increased by $40\% \times \frac{5R}{x\%}$. The flow rate and temperature can be measured past the filter but before leaving the cooling unit. The pump speed can be measured by a variable frequency drive (VFD) which powers the pumps.

Then, a user can input whether the determined dirty filter(s) is cleaned or not in step 724. When the dirty filter(s) is determined to be clean in step 726, a third alarm is outputted to inform the user and the controller about the clean filter status in step 728. On the other hand, if it is determined that the filter(s) is determined to be not clean, the method 700 repeats the process from step 724. Once the third alarm has been generated, the pump(s) turned off in step 722 is turned on as well as the corresponding check valves in step 730 for a normal operation.

The method 700 according to the second embodiment makes it possible to, while the CDU is in a normal operation if the differential pressure is sensed to be higher than the user input value (e.g., first predetermined value), a first alarm (e.g., dirty filter notification) can be triggered. If the differential pressure is then sensed to be higher than the factory preset differential pressure (e.g., second predetermined value), the CDU can then shut down a specific pump or pumps in line of the dirty filter. The process can repeat until there are no more pumps to shut down, without turning off all the pumps or the entire CDU system.

CDU Reduced Pump Speed Filter Protection

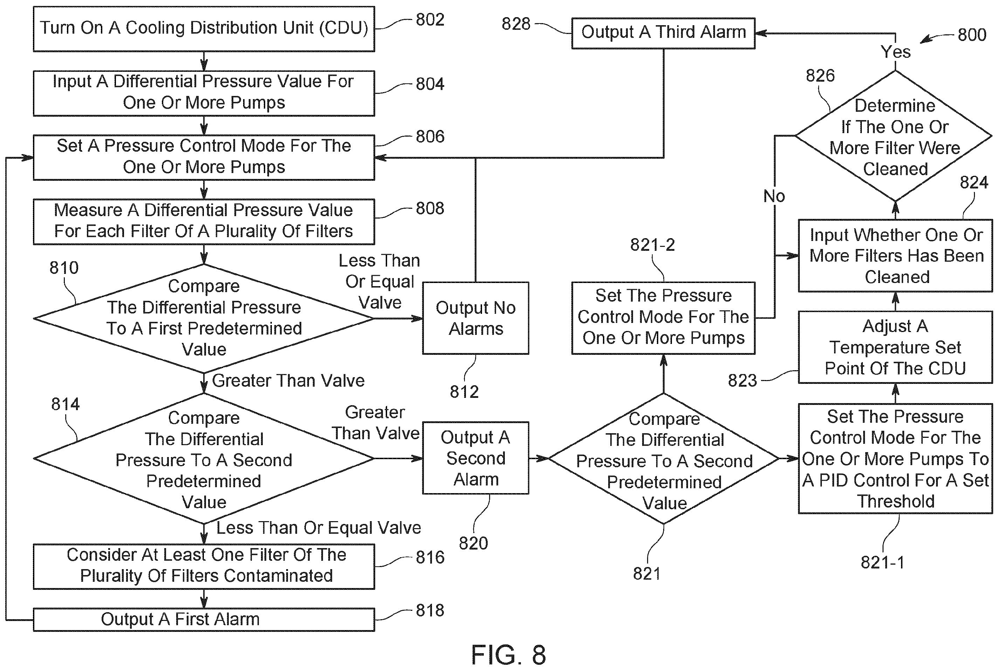

FIG. 8 illustrates a flowchart of a control method 800 according to a third exemplary embodiment of the present disclosure. Similar to the methods 600 and 700, the method 800 may begin with step 802, and steps 804-820 are similar to steps 604-620 of the method 600. Therefore, the detailed description of these steps is omitted herein. However, unlike the method 600 or 700, method 800 proceeds to check again, whether the measured differential pressure is greater than the second predetermined value (e.g., 10 psi) in step 821. If it is determined that the measured differential pressure is less than or equal to the second predetermined value, the method 800 proceeds to step 812-2 to enter the pump control mode, similar to step 806. Then, the user can input whether the filter is cleaned or not in step 824. Alternatively, sensors and the controller of the CDU may determine that the filter is cleaned in step 824. If it is confirmed that the filter is cleaned in step 826, a third alarm is outputted in step 828. On the other hand, if it is determined that the filter is not cleaned in step 826, the method 800 returns to step 821 and repeats the process.

On the other hand, if it is determined that the measured differential pressure is greater than the second predetermined value in step 821, the method 800 proceeds to step 821-1 to enter a pump control mode by a Proportional-Integral-Derivative (PID) control where a threshold for the filter differential pressure may be set to the second predetermined value (e.g., 10 psi). However, this reference value can be adjusted by a user based on cooling and power necessities in the data center. For instance, steps 821 and 821-1 may be set at the same point, or may be set differently by a user or operator. Prior to step 821, the cooling unit is in the pump control mode (e.g., PID External dP). When step 821 verifies that Filter dP has exceeded 10 psi, the cooling unit may enter the loop at step 821-1 and change the PID control to Filter dP instead of External dP.

Then, the method 800 proceeds to step 823 in which a temperature setpoint may be lowered by 5°R for every pump speed reduced by a percentage to compensate for the temperature increase caused by turning off one or more pumps, similar to step 723 of the method 700. In steps 824 and 826, a user can input whether a filter or filters have been cleaned. If "yes," the CDU can output a third alarm (e.g., green light, sound, or haptic) in step 628 to inform a user that the one or more filters are clean, similar to steps 628 and 728 described above with reference to FIGS. 6 and 7, respectively. After the third alarm is generated, the method 800 returns to and repeats the process from step 806.

The method 800 according to the second embodiment makes it possible to, while the CDU is in a normal operation if the differential pressure is sensed to be higher than the user input value (e.g., first predetermined value), a first alarm (e.g., dirty filter notification) will trigger. If the differential pressure is then sensed to be higher than the factory preset differential pressure (e.g., second predetermined value), the CDU may switch to a PID control to control the differential pressure across all filters. The method 800 continues the process until the differential pressures are all within the thresholds.

As described above, each of the CDUs 200 and 300 includes a controller having at least one special-purpose or general purpose processor that, during normal operation, processes data under the control of software, which may include at least one application software, an operating system, middleware, and other code and computer-executable programs accessible from a dynamic storage device such as random access memory (RAM), a static storage device such as Read Only Memory (ROM), a data storage device, such as a mass storage device, or other data storage medium. The software may include but is not limited to, code, applications, protocols, interfaces, and processes for controlling the pumps and valves and other controllable features of the cooling systems of the present disclosure. The controller can further control temperatures of fluid flowing within the CDU and communicate various sensors in the CDU.

In addition, the CDUs 200 and 300 include sensors to detect various sensing data, for example but not limited to, pressure, temperature, speed, volume, etc., and communicate with the respective controllers.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

As used herein, the term "module" refers to logic that may be implemented in a hardware component or device, software or firmware running on a processor unit, or a combination thereof, to perform one or more operations consistent with the present disclosure. Software and firmware may be embodied as instructions and/or data stored on non-transitory computer-readable storage media. As used herein, the term "circuitry" can comprise, singly or in any combination, non-programmable (hardwired) circuitry, programmable circuitry such as processor units, state machine circuitry, and/or firmware that stores instructions executable by programmable circuitry. Modules described herein may, collectively or individually, be embodied as circuitry that forms a part of a computing system. Thus, any of the modules or controllers can be implemented as circuitry, such as gas pressure controller circuitry or working fluid flow rate controller circuitry. A computing system referred to as being programmed to perform a method can be programmed to perform the method via software, hardware, firmware, or combinations thereof.

Any of the disclosed methods (or a portion thereof) can be implemented as computer-executable instructions or a computer program product. Such instructions can cause a computing system or one or more processor units capable of executing computer-executable instructions to perform any of the disclosed methods. As used herein, the term "computer" refers to any computing system or device described or mentioned herein. Thus, the term "computer-executable instruction" refers to instructions that can be executed by any computing system or device described or mentioned herein.

The computer-executable instructions or computer program products as well as any data created and/or used during implementation of the disclosed technologies can be stored on one or more tangible or non-transitory computer-readable storage media, such as volatile memory (e.g., DRAM, SRAM), non-volatile memory (e.g., flash memory, chalcogenide-based phase-change non-volatile memory) optical media discs (e.g., DVDs, CDs), and magnetic storage (e.g., magnetic tape storage, hard disk drives). Computer-readable storage media can be contained in computer-readable storage devices such as solid-state drives, USB flash drives, and memory modules. Alternatively, any of the methods disclosed herein (or a portion) thereof may be performed by hardware components comprising non-programmable circuitry. In some embodiments, any of the methods herein can be performed by a combination of non-programmable hardware components and one or more processing units executing computer-executable instructions stored on computer-readable storage media.

The computer-executable instructions can be part of, for example, an operating system of the computing system, an application stored locally to the computing system, or a remote application accessible to the computing system (e.g., via a web browser). Any of the methods described herein can be performed by computer-executable instructions performed by a single computing system or by one or more networked computing systems operating in a network environment. Computer-executable instructions and updates to the computer-executable instructions can be downloaded to a computing system from a remote server.

Further, it is to be understood that implementation of the disclosed technologies is not limited to any specific computer language or program. For instance, the disclosed technologies can be implemented by software written in C++, C#, Java, Perl, Python, JavaScript, Adobe Flash, C#, assembly language, or any other programming language. Likewise, the disclosed technologies are not limited to any particular computer system or type of hardware.

Furthermore, any of the software-based embodiments (comprising, for example, computer-executable instructions for causing a computer to perform any of the disclosed methods) can be uploaded, downloaded, or remotely accessed through a suitable communication means. Such suitable communication means include, for example, the Internet, the World Wide Web, an intranet, cable (including fiber optic cable), magnetic communications, electromagnetic communications (including RF, microwave, ultrasonic, and infrared communications), electronic communications, or other such communication means.

As used in this application and the claims, a list of items joined by the term "and/or" can mean any combination of the listed items. For example, the phrase "A, B and/or C" can mean A; B; C; A and B; A and C; B and C; or A, B and C. As used in this application and the claims, a list of items joined by the term "at least one of" can mean any combination of the listed terms. For example, the phrase "at least one of A, B or C" can mean A; B; C; A and B; A and C; B and C; or A, B, and C. Moreover, as used in this application and the claims, a list of items joined by the term "one or more of" can mean any combination of the listed terms. For example, the phrase "one or more of A, B and C" can mean A; B; C; A and B; A and C; B and C; or A, B, and C.

The disclosed methods, apparatuses, and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect or feature or combination thereof, nor do the disclosed embodiments require that any one or more specific advantages be present, or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

Although the operations of some of the disclosed methods are described in a particular, sequential order for convenient presentation, it is to be understood that this manner of description encompasses rearrangement, unless a particular ordering is required by specific language set forth herein. For example, operations described sequentially may in some cases be rearranged or performed concurrently. Moreover, for the sake of simplicity, the attached figures may not show the various ways in which the disclosed methods can be used in conjunction with other methods.

**Claims**

1. A method (600) of controlling a coolant distribution unit "CDU" (200, 300), the method comprising steps of:

   starting (602), by a controller, a pump control mode;
   measuring (608), by a sensor, a differential pressure at a filter connected to a pump;
   determining (610), by the controller, whether the differential pressure is greater than a first predetermined value;
   upon determining that the differential pressure is greater than the first predetermined value, determining (614) whether the differential pressure is greater than a second predetermined value, wherein the second predetermined value is greater than the first predetermined value; and
   upon determining that the differential pressure is less than or equal to the second predetermined value, generating (618) a first output.

2. The method according to claim 1, wherein the step of generating the first output comprises determining that the filter is dirty.

3. The method according to claim 1 or 2, further comprising a step of:
   upon determining that the differential pressure is smaller than or equal to the first predetermined value, returning (612) to the step of starting the pump control mode.

4. The method according to any preceding claim, further comprising a step of, after the step of determining whether the differential pressure is greater than a second predetermined value:

   upon determining that the differential pressure is greater than the second predetermined value, generating (620) a second output,
   sand optionally further comprising a step of:
   turning off the pump.

5. The method according to claim 4, wherein, when the CDU comprises a plurality of pumps, the step of turning off the pump comprises turning off all of the plurality of pumps.

6. The method according to claim 4 or 5, further comprising:
   receiving a user input whether the filter is cleaned or not.

7. The method according to claim 6, further comprising:

   upon determining that the filter is cleaned, generating (628) a third output, wherein the first, second, and third outputs are different from each other,
   and optionally further comprising:
   after the third output is generated, turning on the pump.

8. The method according to any preceding claim, further comprising, when the pump and the filter are provided in plural, after the step of determining whether the differential pressure is greater than the first predetermined value, a step of:
   determining a specific filter having the differential pressure greater than the first predetermined value among the plurality of filters.

9. The method according to claim 8, further comprising a step of:
   determining whether the differential pressure of the specific filter is greater than the second predetermined value.

10. The method according to claim 9, further comprising a step of:

> upon determining that the differential pressure of the specific filter is greater than the second predetermined value, generating a second output and turning off a specific pump in fluid communication with the specific filter
>
> and optionally further comprising a step of:
>
>> decreasing, by the controller, a temperature setpoint based on a pump speed decrease, and further optionally further comprising a step of:
>> turning on the specific pump when it is determined that the specific filter in fluid communication with the pump is cleaned.

11. The method according to any preceding claim, further comprising a step of, after the step of determining whether the differential pressure is greater than a second predetermined value:

> upon determining that the differential pressure is greater than the second predetermined value, generating a second output; and
> determining again whether the differential pressure is greater than the second predetermined value.

12. The method according to claim 11, further comprising a step of:

> upon determining that the differential pressure is greater than the second predetermined value, setting, by the controller, a filter setpoint; and decreasing, by the controller, a temperature setpoint based on a pump speed decrease.

13. The method according to claim 11 or 12, further comprising a step of:

> upon determining that the differential pressure is smaller than or equal to the second predetermined value, receiving a user input whether the filter has been cleaned or not,
> and optionally further comprising a step of:
> upon determining that the filter is cleaned, generating a third output, wherein the first, second, and third outputs are different from each other.

14. A coolant distribution unit (200) comprising:

> a heat exchanger (218, 402);
> a pump (220) selectively communicating with the heat exchanger by a valve;
> a filter (232) communicating with the pump;
> a sensor configured to a differential pressure at the filter connected to the pump; and

> a controller (202) configured to start a pump control mode and determine whether the differential pressure is greater than a first predetermined value,
> wherein, when the differential pressure is greater than a second predetermined value, the controller determines that the differential pressure is greater than the first predetermined value, the second predetermined value being greater than the first predetermined value, and
> wherein, when the differential pressure is less than or equal to the second predetermined value, the controller generates a first output.

15. The coolant distribution unit of claim 14, wherein the pump and the filter are provided in plural.

100

FIG. 1

FIG. 2A

FIG. 2B

**FIG. 3**

EP 4 696 890 A1

400

Room Temp/RH Sensor (s)

Controller & Display

T3a  T3b

RHa  RHb

(Optional Redundant)

404

Expansion Vessels

Water Level Sensors

(Redundant)

406

VFD  PS5a

Auto Air-vent

By-pass

PS3  PS4

T1

Chilled Water Flow/Return

Flowmeter

Filter & Pressure Sensors(optional)

Pump P1

408

Relief Valve

T2a  T2b  T2c  PS2

(Redundant)  (Redundant)

Shut-off valve for 2-way control valve operation

Heat Exchanger

VFD  PS5b

Fill Pump P3

Fill point

Pump P2 (Redundant)

Filters (optional)

T5

Cooling Control Valve

402

Flowmeter

T4  PS1a  PS1b

(Redundant)

FIG. 4

FIG. 5

FIG. 6

EP 4 696 890 A1

FIG. 7

FIG. 8

EP 4 696 890 A1

Europäisches
Patentamt

European
Patent Office

Office européen
des brevets

## EUROPEAN SEARCH REPORT

Application Number

EP 25 19 5046

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2023 179317 A (TOYOTA MOTOR CORP. [JP]) 19 December 2023 (2023-12-19) | 1-4,6,7, 11,13-15 | INV. F04B49/02 |
| A | * figures 1, 2 * <br> * paragraph [0041] - paragraph [0053] * <br> * paragraph [0026] - paragraph [0031] * <br> ----- | 5,8-10, 12 | F04B49/06 <br> F04B49/08 <br> F04B53/20 <br> F24F11/39 |
| Y | CN 117 490 320 A (INDUSTRIAL & COMMERCIAL BANK OF CHINA CO., LTD. [CN]) 2 February 2024 (2024-02-02) | 1-4,11, 14 | |
| A | * paragraph [0039] - paragraph [0050] * <br> * claim 1 * <br> * figure 1 * <br> ----- | 5-10,12, 13,15 | |
| Y | CN 110 567 096 A (SICHUAN SUJING MECH & ELECTRICAL EQUIPMENT CO., LTD. [CN]) 13 December 2019 (2019-12-13) | 1-4,11, 14 | |
| A | * claims 1,2 * <br> * paragraph [0023] - paragraph [0032] * <br> ----- | 5-10,12, 13,15 | |
| A | US 4 692 253 A (HITACHI LTD. [JP]) 8 September 1987 (1987-09-08) * column 4, line 39 - column 6, line 57 * <br> ----- | 1-15 | TECHNICAL FIELDS SEARCHED (IPC) |
| | | | F04B <br> F24F |

The present search report has been drawn up for all claims

| Place of search | Date of completion of the search | Examiner |
|---|---|---|
| Munich | 4 December 2025 | Gnüchtel, Frank |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
........................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 19 5046

04-12-2025

| Patent document cited in search report | | Publication date | Patent family member(s) | | Publication date |
|---|---|---|---|---|---|
| JP 2023179317 | A | 19-12-2023 | NONE | | |
| CN 117490320 | A | 02-02-2024 | NONE | | |
| CN 110567096 | A | 13-12-2019 | NONE | | |
| US 4692253 | A | 08-09-1987 | CA | 1254520 A | 23-05-1989 |
| | | | DE | 3428428 A1 | 21-02-1985 |
| | | | JP | S6030990 A | 16-02-1985 |
| | | | JP | S6255074 B2 | 18-11-1987 |
| | | | US | 4692253 A | 08-09-1987 |